Europäisches Patentamt

(19) European Patent Office

Office européen des brevets

(11) EP 0 963 250 B1

(12) EUROPEAN PATENT SPECIFICATION

(45) Date of publication and mention
of the grant of the patent:
**19.12.2001 Bulletin 2001/51**

(51) Int Cl.[7]: **B01L 7/00**, C12Q 1/68,
H01L 35/28, F25B 21/02

(21) Application number: 98913265.9

(22) Date of filing: 30.03.1998

(86) International application number:
PCT/US98/06189

(87) International publication number:
WO 98/43740 (08.10.1998 Gazette 1998/40)

(54) **IMPROVEMENTS IN THERMAL CYCLER FOR PCR**

THERMO-ZYKLUS-VORRICHTUNG ZUR AUSFÜHRUNG DER
POLYMERASE-KETTENREAKTION

AMELIORATIONS APPORTEES A UN CYCLEUR THERMIQUE POUR PCR

(84) Designated Contracting States:
**AT BE CH DE DK ES FI FR GB GR IE IT LI LU MC
NL PT SE**

(30) Priority: **28.03.1997 US 41754 P
09.05.1997 US 46122 P**

(43) Date of publication of application:
**15.12.1999 Bulletin 1999/50**

(60) Divisional application:
**01112394.0 / 1 127 619**

(73) Proprietor: **PE Corporation (NY)
Foster City California 94404 (US)**

(72) Inventors:
• **ATWOOD, John, G.**
**West Redding, CT 06896 (US)**
• **FAWCETT, Adrian**
**Pleasanton, California 94588 (US)**
• **FERRARA, Keith, S.**
**Stratford, CT 06497 (US)**
• **HETHERINGTON, Paul, M.**
**Goldens Bridge, NY 10526 (US)**
• **NOREIKS, Richard, W.**
**Stratford, CT 06497 (US)**
• **OLSEN, Douglas, E.**
**New Fairfield, CT 06812 (US)**
• **WIDOMSKI, John, R.**
**Shelton, CT 06484 (US)**
• **WITTMER, Charles, M.**
**Trumbull, CT 06611 (US)**

(74) Representative: **Vossius, Tilman et al
Dr. Volker Vossius, Patent- und
Rechtsanwaltskanzlei, Holbeinstrasse 5
81679 München (DE)**

(56) References cited:
EP-A- 0 236 069    EP-A- 0 342 155
EP-A- 0 362 173    EP-A- 0 488 769
EP-A- 0 640 828    EP-A- 0 642 828
EP-A- 0 642 831    WO-A-93/09486
WO-A-95/27196    WO-A-97/21089
DE-A- 4 037 955    US-A- 4 639 883
US-A- 4 865 986    US-A- 4 881 038
US-A- 5 040 381    US-A- 5 237 821
US-A- 5 248 934    US-A- 5 385 022
US-A- 5 410 130    US-A- 5 431 021
US-A- 5 441 576    US-A- 5 600 575

**Description**

## FIELD OF THE INVENTION

This invention pertains to the field of computer controlled instruments for performing the Polymerase Chain Reaction (PCR). More particularly, the invention pertains to automated instruments that perform the reaction simultaneously on many samples and produce very precise results by using thermal cycling.

## BACKGROUND OF THE INVENTION

The background of the invention is substantially as stated in U.S. Patent No. 5,475,610.

To amplify DNA (Deoxyribose Nucliec Acid) using the PCR process, it is necessary to cycle a specially constituted liquid reaction mixture through several different temperature incubation periods. The reaction mixture is comprised of various components including the DNA to be amplified and at least two primers sufficiently complementary to the sample DNA to be able to create extension products of the DNA being amplified. A key to PCR is the concept of thermal cycling: alternating steps of melting DNA, annealing short primers to the resulting single strands, and extending those primers to make new copies of double-stranded DNA. In thermal cycling the PCR reaction mixture is repeatedly cycled from high temperatures of around 90°C for melting the DNA, to lower temperatures of approximately 40°C to 70°C for primer annealing and extension. Generally, it is desirable to change the sample temperature to the next temperature in the cycle as rapidly as possible. The chemical reaction has an optimum temperature for each of its stages. Thus, less time spent at non optimum temperature means a better chemical result is achieved. Also a minimum time for holding the reaction mixture at each incubation temperature is required after each said incubation temperature is reached. These minimum incubation times establish the minimum time it takes to complete a cycle. Any time in transition between sample incubation temperatures is time added to this minimum cycle time. Since the number of cycles is fairly large, this additional time unnecessarily heightens the total time needed to complete the amplification.

In some previous automated PCR instruments, sample tubes are inserted into sample wells on a metal block. To perform the PCR process, the temperature of the metal block is cycled according to prescribed temperatures and times specified by the user in a PCR protocol file. The cycling is controlled by a computer and associated electronics. As the metal block changes temperature, the samples in the various tubes experience similar changes in temperature. However, in these previous instruments differences in sample temperature are generated by non-uniformity of temperature from place to place within the sample metal block. Temperature gradients exist within the material of the block, causing some samples to have different temperatures than others at particular times in the cycle. Further, there are delays in transferring heat from the sample block to the sample, and those delays differ across the sample block. These differences in temperature and delays in heat transfer cause the yield of the PCR process to differ from sample vial to sample vial. To perform the PCR process successfully and efficiently, and to enable so-called quantitative PCR, these time delays and temperature errors must be minimized to the greatest extent possible. The problems of minimizing non-uniformity in temperature at various points on the sample block, and time required for and delays in heat transfer to and from the sample become particularly acute when the size of the region containing samples becomes large as in the standard 8 by 12 microtiter plate.

Another problem with current automated PCR instruments is accurately predicting the actual temperature of the reaction mixture during temperature cycling. Because the chemical reaction of the mixture has an optimum temperature for each of its stages, achieving that actual temperature is critical for good analytical results. Actual measurement of the temperature of the mixture in each vial is impractical because of the small volume of each vial and the large number of vials.

## SUMMARY OF THE INVENTION

According to the invention, there is provided an apparatus for performing the polymerase chain reaction in a plurality of liquid reaction mixtures; said apparatus including a plurality of vials containing such liquid reaction mixtures, said vials having an upper portion and a lower portion; said apparatus comprising:

an assembly for cycling said vials through a series of temperature excursions;
a heated cover for applying a seating force to said vials and for applying a constant temperature to the upper portion of said vials; and
a computing apparatus for controlling said temperature excursions of said assembly and said constant temperature of said cover;
said assembly comprising:

a sample block for receiving said vials;

a plurality of thermoelectric devices;

a heat sink;

a clamping mechanism positioned so as to clamp said thermoelectric devices between said sample block and said heatsink;

a heater positioned loosely around the perimeter of said sample block; and

a pin having a first end and a second end, said first end in close contact with said sample block and said second end in close contact with said heatsink so as to provide a thermal path between said sample block and said heatsink.

The invention is also directed to the use of the above apparatus for performing the polymerase chain reaction.

## BRIEF DESCRIPTION OF THE DRAWINGS

Figure 1 is a cross sectional view of a portion of the sample block used in the apparatus according to the invention.

Figure 2 is an enlarged, isometric view of a thermoelectric device used in the apparatus according to the invention.

Figure 2A is a side, elevational view of the thermoelectric device.

Figure 3 is a cut-away, partial, isometric view of the heatsink used in the apparatus according to the invention.

Figure 4 is an exploded view of an assembly including a sample block, thermoelectric devices and heatsink.

Figure 5 is an isometric view of the heated cover used in the apparatus in accordance with the invention .

Figure 6 is a chart depicting the Up Ramp (heating rate) vs. Power.

Figure 7 is a chart depicting the Down Ramp (cooling rate) vs. Power.

Figure 8 is a chart for predicting and compensating for temperature overshoots and undershoots.

Figure 9 is a block diagram of the AC resistance measurement circuit.

Figure 10 shows a perimeter heater and its location surrounding the sample block.

Figure 11 is a detailed view of the perimeter heater of Figure 10.

Figure 12 shows the power applied to the perimeter heater as a function of the temperature of the sample block.

Figure 13 shows a thermal model of a sample in a sample vial.

Figure 14 is an illustration of the initial conditions of the thermal model of Figure 13.

Figure 15 shows the sample block and a seal designed to protect the thermoelectric devices from the environment.

## DETAILED DESCRIPTION OF THE INVENTION

Generally, in the case of PCR, it is desirable to change the sample temperature between the required temperatures in the cycle as quickly as possible for several reasons. First the chemical reaction has an optimum temperature for each of it's stages and as such less time spent at non-optimum temperatures means a better chemical result is achieved. Secondly a minimum time is usually required at any given set point which sets a minimum cycle time for each protocol and any time spent in transition between set points adds to this minimum time. Since the number of cycles is usually quite large, this transition time can significantly add to the total time needed to complete the amplification.

The absolute temperature that each reaction tube attains during each step of the protocol is critical to the yield of product. As the products are frequently subjected to quantitation, the product yield from tube to tube must be as uniform as possible and therefore both the steady-state and dynamic thermal uniformity must be excellent across the block.

Heat-pumping into and out of the samples is accomplished by using Peltier thermoelectric devices. These are constructed of pellets of n-type and p-type bismuth telluride connected alternately in series. The interconnections between the pellets is made with copper which is bonded to a substrate, usually a ceramic (typically alumina).

The amount of heat-pumping required is dependent on the thermal load and the ramp rate, that is, the rate at which the temperature is required to change. The sample tube geometry and sample volumes are not variables as the sample tubes are established as an industry standard, fitting into many other types of instruments such as centrifuges. The sample volume is defined by user need. Therefore the design variables primarily affect the sample block, thermoelectric devices, heatsink, fan and the thermal interface media between the thermoelectric devices and both the heatsink and the sample block.

The block geometry must also meet the necessary thermal uniformity requirements because it is the primary contributor to lateral conduction and therefore evens out any variation in thermal uniformity of the thermoelectric coolers themselves. The conflicting requirements of rapid ramp rates (indicating low thermal mass) and high lateral conduction (indicating a large material mass) are met by concentrating the bulk of the block structure in a base plate, and minimizing the thermal mass of the upper portion of the block which holds the sample tubes. The optimal material for block fabrication is pure silver which has relatively low thermal mass and very good thermal conduction. Silver also lends itself well to electroforming. In practice the optimal block geometry has a light electroformed upper portion to hold the sample tubes fixed to a relatively thick base plate which provides lateral conduction. The thermal mass of the block is concentrated in the base plate where the material contributes the most to thermal uniformity. The electroformed portion of the block has a minimum thickness which is defined by two parameters: first, the material cannot be so thin as to make it too delicate for normal handling; second, the wall thickness is required to conduct heat out of the upper regions of the sample tube. Circulation in the sample itself is achieved by convection inside the tube and sample temperature is relatively uniform along the height of the tube, but good thermal conductivity between the tube walls and the base plate increases the effective surface area available for conduction of heat between the sample and the base plate. The base plate thickness has a minimum value defined by lateral conduction requirements which is a function of the thermal uniformity of the thermoelectric coolers and structural rigidity.

Another contributor to the thermal mass is the alumina ceramic layers which form part of the structure of the thermoelectric cooler itself. There are two alumina layers in the construction of the thermoelectric cooler, one on the sample block side and another on the heatsink side. The thickness of the layers should be minimized as much as possible, in this case the practical limit of thinness for the alumina thickness is defined by the manufacturing requirements of thermoelectric cooler fabrication. This particular layer of ceramic could in principal be replaced by a different layer altogether such as a thin sheet of Kapton which would reduce the thermal mass even more, but at the present time although coolers are available with this structure, reliability is unproven. It is anticipated that once the technology has been developed further, then a cooler of such a design may be preferred. However, the thin alumina layers also contribute to system reliability.

The copper conductors within the cooler are a significant thermal load and are not overlooked in the design of the system. The thickness of the copper traces is defined by the requirement of carrying current through the device. Once the current is known the required copper thickness can be calculated.

## Sample Block

Figure I shows a cross sectional view of a portion of the sample block **36** which typically has **96** wells **20**, each for receiving a sample vial. The sample block is constructed of silver and comprises an upper support plate **21** and the sample wells **20** electroformed as one piece fastened to a base plate **22**. The base plate **22** provides lateral conduction to compensate for any difference in the thermal power output across the surface of each individual thermal electric device and for differences from one thermal electric device to another.

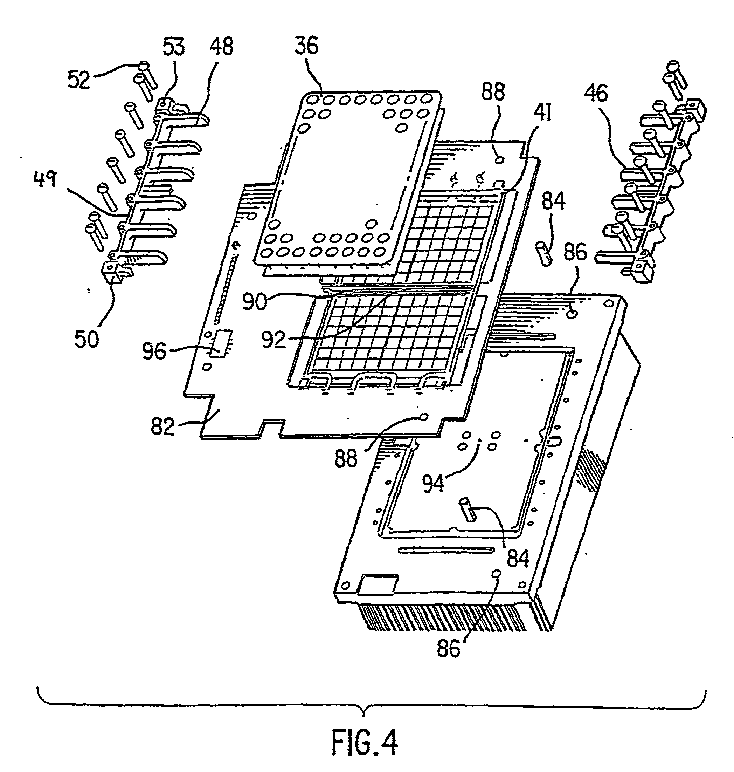

There are always boundary losses in any thermal system. In a rectangular configuration there is more heat loss in the corners. One solution is to use a round sample block, but the microtiter tray format that is in common usage is rectangular and this must be used to retain compatibility with other existing equipment. Once the edge effects have been eliminated using all standard means, such as insulation etc., there remains a tendency for the center of the sample block to be warmer than the comers. Typically it is this temperature difference that defines the thermal uniformity of the sample block. In accordance with the invention, the center temperature is reduced by providing a small thermal connection from the center of the sample block to the heat sink. By using a pin **24** which acts as a "heat leak" in the center of the sample block, the temperature gradient across the sample block can be reduced to an acceptable level. The amount of conduction required is quite small and a 1.5mm diameter stainless steel pin has been found to be sufficient. Moreover, a pin made of the polymer ULTEM, manufactured by General Electric may also be used. As more fully described below, the pin also serves to help position and lock into place components of the assembly illustrated in Figure 4.

## Peltier Thermal Electric Devices (TED's)

Thermal uniformity of the sample block is critical to PCR performance. One of the most significant factors affecting the uniformity is variations in the thermal electric device performance between devices. The most difficult point at which to achieve good uniformity is during a constant temperature cycle far from ambient. In practice this is a constant temperature cycle at approximately 95°C. The thermal electric devices are matched under these conditions to make a set of devices for each heatsink assembly which individually produce the same temperature for a given input current. The thermal electric devices are matched to within 0.2°C in any given set, this value being derived from the maximum discrepancy that can be rectified by the lateral conduction of the sample block baseplate.

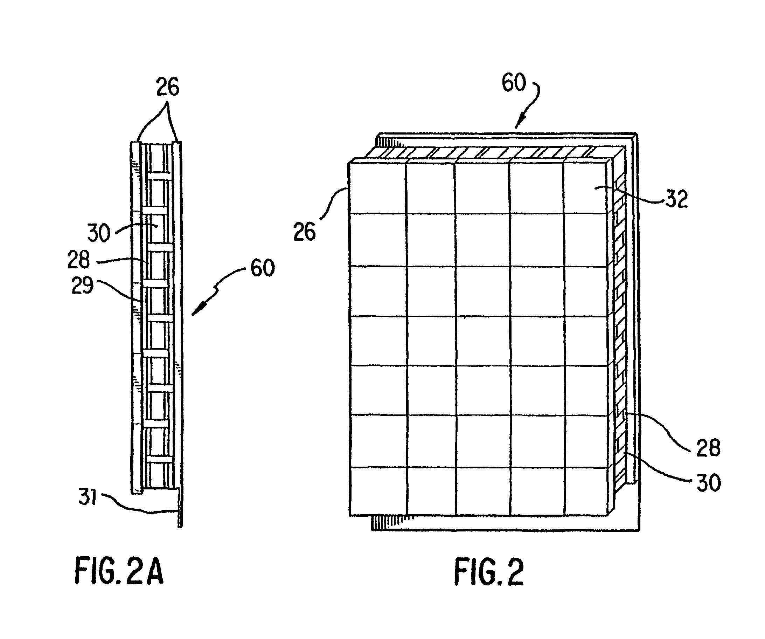

Figure 2A shows a side view of a typical Peltier thermal electric device **60**. The device is composed of bismuth telluride pellets **30**, sandwiched between two alumina layers **26**. The pellets are electrically connected by solder joints **28** to copper traces **29** plated onto the alumina layers. One alumina layer has an extension **31** to facilitate electrical connections. The thickness of the extended areas is reduced to decrease the thermal load of the device.

Figure 2 shows an isometric view of a typical Peltier thermal electric device. The alumina layer **26** that forms the outer wall of the thermal electric device, expands and contracts during temperature cycling at a different rate than the sample block **19**. The motion of the alumina is transmitted directly to the solder **28** connecting the internal bismuth telluride pellets **30**. This motion can be reduced dramatically by cutting the alumina into small pieces **32** called die so that the field of expansion is small. The minimum size of the die is defined by the size of the copper traces required to carry current through the thermal electric device and the requuirements that the device retain some strength for handling.

Using thin alumina layers in the thermal electric device (of the order of 0.508 mm) not only reduces the thermal load but also means that for a given required heat pumping rate the temperature that the ends of the pellet reaches is reduced due to the increase in thermal conductivity **k**. This enhances reliability by reducing the thermal stress on the solder joint.

Generally in PCR the reaction temperatures are above ambient and in the range 35 to 96°C. In the most important cases the block is heated or cooled between two above ambient temperatures where the flow of heat due to conduction is from the block to the heat sink. The key to optimizing the system cycle time, given an optimized block configuration, is to balance the boost to the ramp rate when cooling provided by the conduction, against the boost provided to the heating ramp rate by the Joule effect of resistance heating.

If the cross-section of the bismuth telluride pellets in a given thermal electric device were considered constant, the heating ramp rate would be increased by increasing the height of the pellet. This is because the conduction path through the thermal electric device would be made longer thereby decreasing **k**. This also has the effect of reducing the current required to maintain a given block temperature in the steady state. During the down ramp, i.e. cooling the block, the decreased **k** means that the conduction contribution will be reduced and so the down ramp rate will be reduced.

Conversely, if the height of the bismuth telluride pellet were to be decreased for a given cross-section, then **k** would be increased. This would increase the current required to maintain an elevated temperature in the steady state and would increase the cooling ramp rate. Heating ramp rates would be reduced as a larger portion of the heat in the block would be conducted directly to the heat sink. Decreasing the bismuth telluride pellet height also increases the holding power required for a given temperature due to the losses through the thermal electric devices and reduces the thermal load, increasing the maximum possible ramp rate for given power. Therefore the optimized thermal electric device can be derived by adjusting the height of the Bismuth Telluride pellets until the heating rate matches the cooling rate.

The ratio 1:A for the pellets also defines the resistance of the device i.e.

$$R=nr(h/A)$$

where n is the number of pellets, r is the resistivity of the Bismuth Telluride being used, h is the height of the pellet and A is the cross-sectional area.

The resistance must be measured as an AC resistance because of the Seebeck effect. Because the geometry defines the resistance of the device, another design boundary is encountered in that the device must use a cost effective current to voltage ratio because too high a current requirement pushes up the cost of the amplifier. The balanced solution for the silver electroformed block described above is :

Pellet height = 1.27mm
Pellet cross-sectional area = 5.95mm$^2$

If the thermal cycler was to be used as part of another instrument, e.g. integrated with detection technology, then it may be more convenient to use a different current source which would lead to a modified thermal electric device geometry. The current source in the present embodiment consists of a class D type switch-mode power amplifier with a current sending resistor in series with the device and ground.

Because the thermal electric devices are soldered together, excess solder can wick up the side of the bismuth telluride pellets. Where this occurs, k is increased which results in a local cold spot, also called a mild spot. These cold spots are reduced in number and severity by application of the minimum amount of solder during the assembly process of the thermal electric device. For the same reason, it is also necessary to ensure that the solder used to attach the connecting wires to the thermal electric device does not contact the pellet

High temperature solder has been shown to not only have improved high temperature performance but it is also generally more resistant to failure by stress reversals and hence is most appropriate in this application. The solder used in this invention may be of the type as described in U.S. Patent 5,441,576.

**Heatsink**

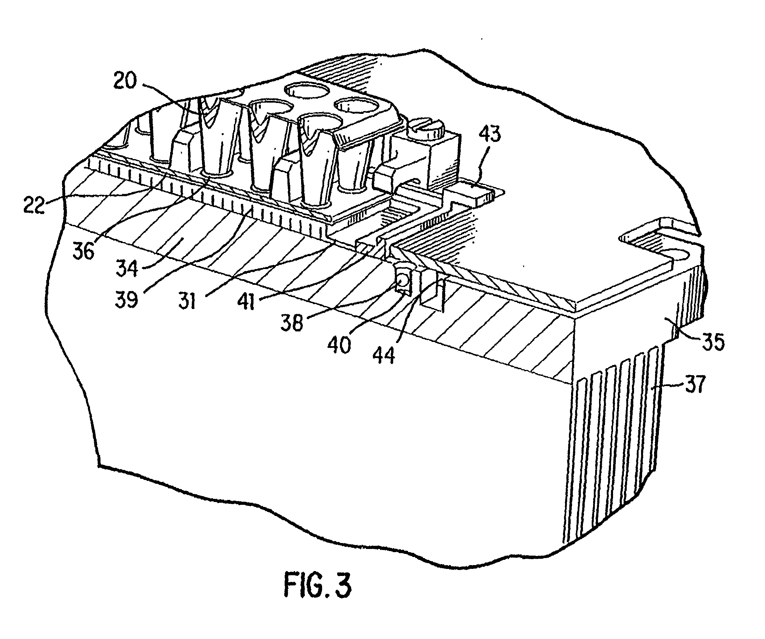

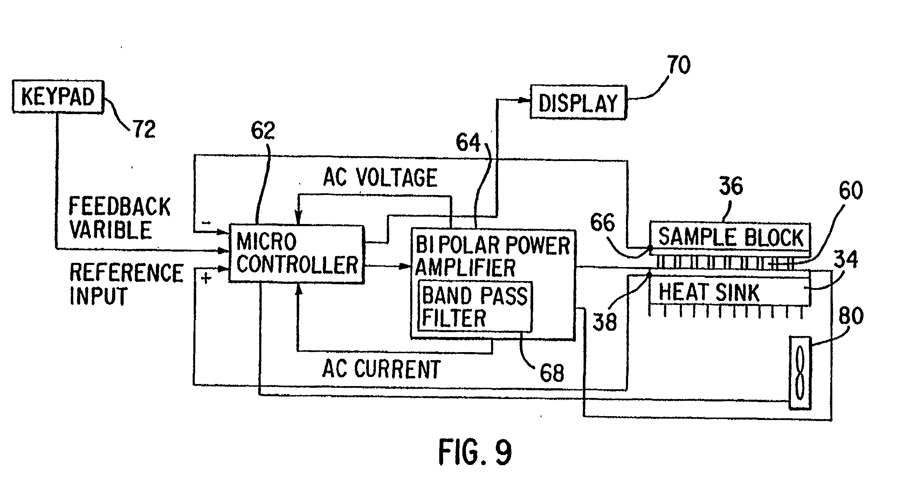

Figure 3 shows the heatsink **34** assembled with the thermal electric devices **39** and the sample block **36**. A locating frame **41** is positioned around the thermal electric devices to align them with the sample block and the heatsink to ensure temperature uniformity across the sample block. The frame is composed of Ultem or other suitable material and has tabs **43** at its corners to facilitate handling. The heatsink **34** has a generally planar base **35** and fins **37** extending from base **35**. The thermal mass of the heat sink is considerably larger than the thermal mass of the sample block and samples combined. The sample block and samples together have a thermal mass of approximately 100 joules/°K and that of the heat sink is approximately 900 joules/°K. This means that the sample block clearly changes temperature much faster than the heat sink for a given amount of heat pumped. In addition the heat sink temperature is controlled with a variable speed fan as shown in Figure 9). The temperature of the heat sink is measured by a thermistor **38** placed in a recess **40** within the heatsink and the fan speed is varied to hold the heat sink at approximately 45°C which is well within the normal PCR cycling temperature range, where maintaining a stable heat sink temperature improves the repeatability of system performance. When the block temperature is set to a value below ambient then the heat sink is set to the coolest achievable temperature to reduce system power consumption and optimize block thermal uniformity. This is accomplished simply operating the fan at full speed.

The heat sink temperature measurement is also used by the thermal electric device control algorithm described below in linearizing the thermal output power from the thermal electric devices.

The heatsink temperature uniformity is reflected in the uniformity of the block temperature. Typically the heatsink is warmer in the middle than it is at the edges and this adds to other effects that lead to the corners of the block being the coldest. A trench **44** is cut into the heat sink outside the perimeter of the thermal electric device area to limit the conduction of heat and decreases edge losses from the area bounded by the trench.

**Thermal Interface and Clamping Mechanism**

Thermal electric device manufacturers recommend that thermal electric devices be held under pressure to improve life-expectancy. (The pressure recommended is often defined by the thermal interface media selected.) The pressure that is recommended varies from manufacturer to manufacturer but is in the range of 2.1 bar to 6.9 bar (30 to 100 psi) for cycling applications.

There are many thermal interface media available in sheet form which can be used to act as a compliant layer on each side of the thermal electric devices, but it has been demonstrated that thermal grease gives far superior thermal performance for this application. Unlike other compliant sheets which have been shown to require 2.1 bar (30 psi) or more even under optimal conditions. Thermal grease does not require high pressure to ensure that good thermal contact has been made. Also thermal grease acts as an effective lubricant between the expanding and contracting silver block and the thermal electric device surface, enhancing life-expectancy. Thermalcote II thermal grease manufactured by Thermalloy, Inc. may be used.

Because the silver block is relatively flexible and soft it cannot transmit lateral clamping pressure very effectively. However, because the thermal interface media is thermal grease, the clamping force required is low.

Figure 4 shows an exploded view of the assembly with the preferred embodiment of the clamping mechanism. Each clamp **46** is made up of a series of fingers **48** extending from a spine **49**. The fingers **48** are sized, shaped and spaced so as to fit between the wells **20** of the sample block **36** and thus apply pressure at a corresponding series of points on the base plate **22** of the sample block **36**. The open honeycomb structure of the electroformed sample wells allows the fingers to be inserted some distance into the block, thereby applying the pressure more evenly than an edge clamping scheme would. These fingers apply pressure at a series of local points to minimize the contact area between the mass of the clamp and the sample block so that the clamp does not add significantly to the thermal load. The clamps are molded from a glass filled plastic which has the necessary rigidity for this application. The pressure is applied by deforming the fingers with respect to mounting posts **50** which may be separate clamp structures, but are preferably integrally formed with the clamps **46**. The clamps **46** are held flush to the surface of the heat sink with a series of screws **52** extending through corresponding hole **53** in clamps **46** and then into threaded holes **55** in heatsink **34**. This scheme eliminates the necessity to set the pressure with adjustment screws as the clamps can simply be tightened down by standard torqueing techniques.

The resulting even pressure distribution ensures that the full area of the thermal electric devices is in good thermal contact with the block and the heatsink reducing local thermal stresses on the thermal electric devices.

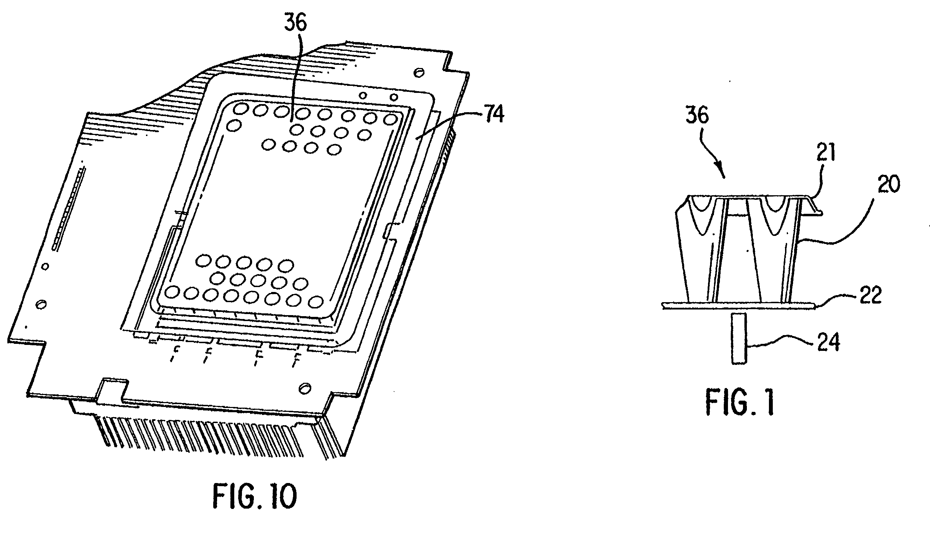

Figure 4 shows other important features of the invention. A printed circuit board **82** a memory device **96** for storing data and surrounds the thermal electric devices and provides electrical connections. Alignment pins **84** are seated in holes **86** in the heatsink and protrudes through alignment holes **88** to align the printed circuit board with the heatsink. The locating frame **41** is positioned around the thermal electric devices and has a cross beam **90** with a through hold **92**. Pin **24** (shown in Figure 1) fits into a hole (not shown) in the sample block, extends through hold **92** in the locating frame and further extends into hole **94** in the heatsink.

### Perimeter Heater

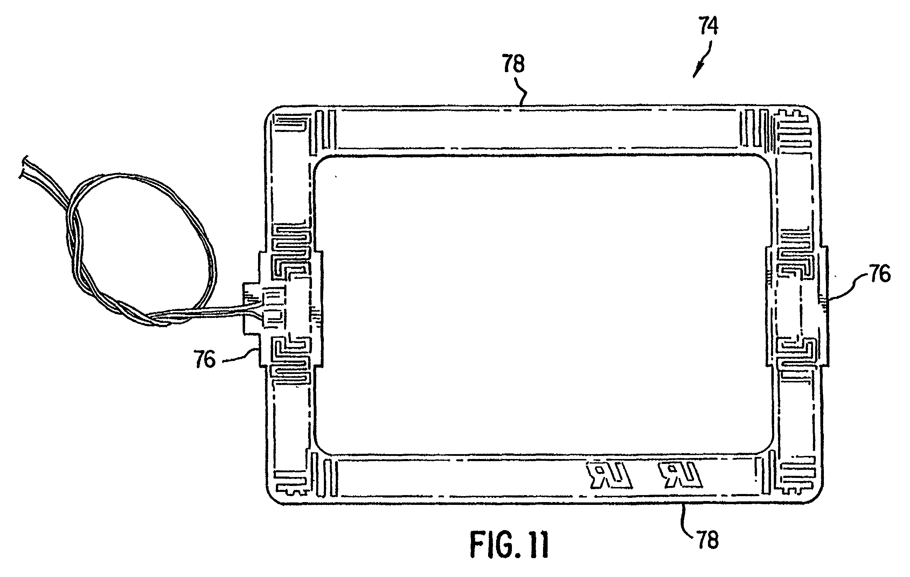

In order to bring the temperature uniformity across the sample block to approximately ±0.2°C, a perimeter heater is positioned around the sample block to eliminate heat losses from its edges. Preferably, the heater is a film type, having low mass with inside dimensions slightly larger than the sample block. Figure 10 shows the perimeter heater **74** and its approximate location surrounding the sample block **36**. The heater is not fastened in place, it is simply positioned in the air around the perimeter of the sample block in order to warm the air in the immediate vicinity.

Figure 11 shows a detailed view of the perimeter heater **74**. The heater is rectangular as determined by the dimensions ofthe sample block and is manufactured so that it has separate power densities in specific areas to reflect the varying amounts of heat. loss around the perimeter of the block. Matching lower power density regions **76** (0.113 W/cm$^2$) (0.73 W/in$^2$) are located in the center portions of the short sides of the rectangle and matching higher power density regions **78** (0.202 W/cm$^2$) (1.3 W/in$^2$) are located in the longer sides, extending into the shorter sides.

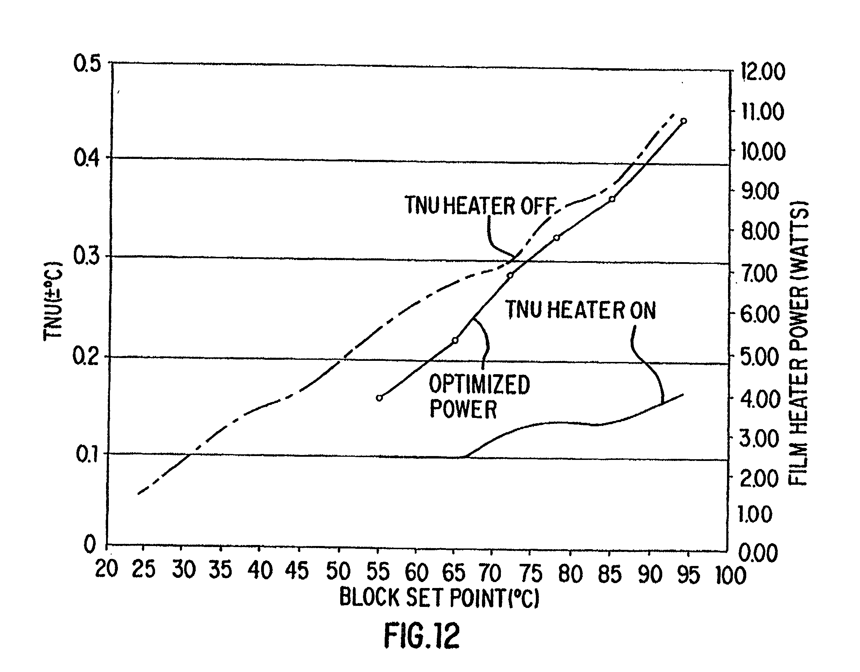

As shown in Figure 12, the power applied to the perimeter heater is regulated to correspond to the temperature of the sample block, with more power applied to the heater at higher block temperatures and less applied at lower block temperatures.

### Heated Cover:

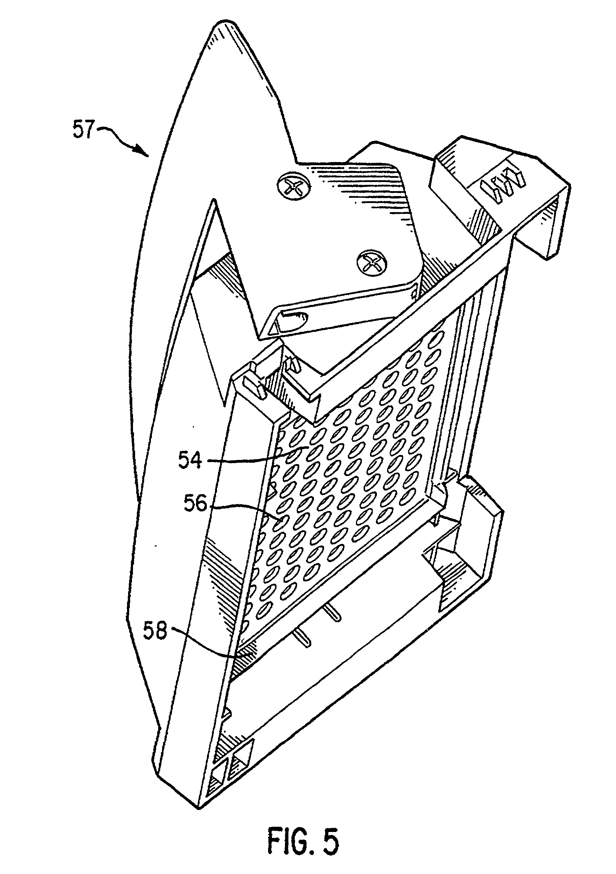

Figure 5 shows the heated cover **57**. The heated cover applies pressure to the sample vial caps to ensure that they remain tightly closed when the sample is heated.

Further, pressure transferred to the vials assures good thermal contact with the sample block. The cover is heated under computer control to a temperature above that of the sample to ensure that the liquid does not condense onto the tube cap and instead remains in the bottom of the tube where thermal cycling occurs. This is described in United States Patent No. 5,475,610, mentioned above. The heated platen **54** in the present invention does not press on the dome of the cap but instead presses on the cap perimeter. The platen has a surface shaped in this manner so that optical caps are not distorted by the application of pressure. Thus, tubes that have been cycled can be directly transferred to an optical reader without the need to change the cap.

Because the heated platen has recesses **56** in it to clear the cap domes, there is a need to align the plate to the tube positions before applying pressure to avoid damage to the tubes. This is accomplished by use of a "skirt" **58** around the perimeter of the platen which aligns to the microtiter tray before the plate touches the tube caps. The cover has a sliding mechanism similar to that used on the PYRIS Differential Scanning Calorimeter by the Perkin Elmer Corporation allowing the cover to slide back to allow sample vials to be inserted into the sample block and forward to cover the sample block and move down engage the vials.

### Determining the Ideal Ramp Rate:

The optimized ramp rate has been empirically determined to be 4°C/sec. Any system which has a higher block ramp rate than this cannot fully utilize the benefits temperature of overshoots and consequently achieves an insignificant reduction in cycle time.

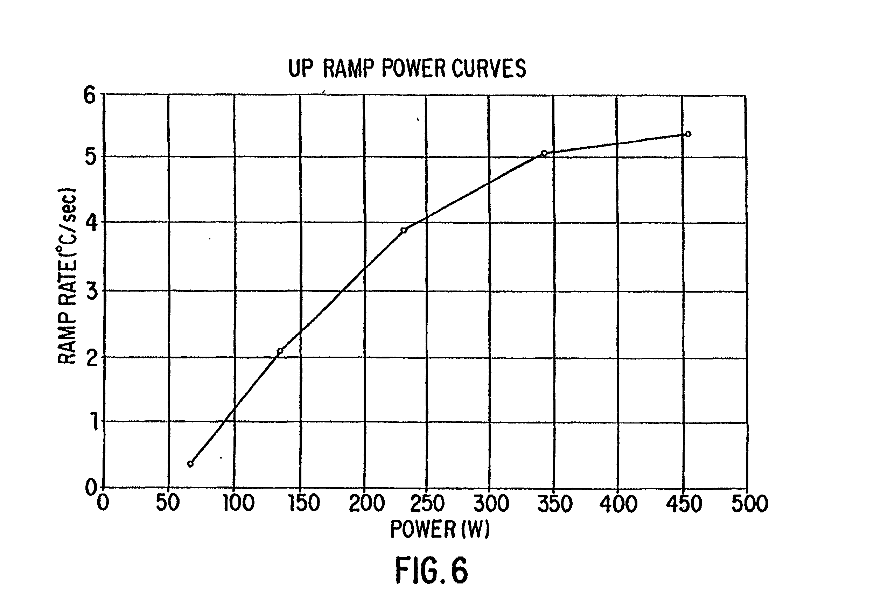

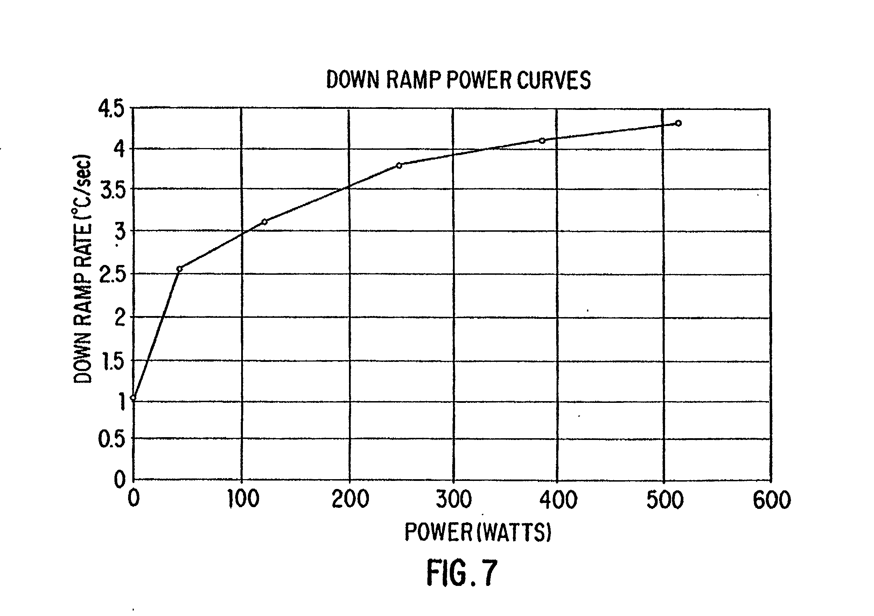

Figure 6 is a chart depicting the Up Ramp (heating rate) vs. Power and Figure 7 is a chart depicting the Down Ramp (cooling rate) vs. Power.

When heating the block to a temperature above ambient, the Joule heating and the Seebeck heat pumping both act to heat the sample block against conduction. When cooling the block between two temperatures above ambient, the Seebeck heat pumping and conduction act against the Joule heating. During cooling, significant power is required to hold the block temperature steady against the flow of heat out of the block by conduction. Therefore even with zero power applied, the block will cool at a significant rate. As the current is increased, the Seebeck effect increases the cooling obtained. However as the current is increased further the joule effect, which is proportional to the square of the current, quickly starts to take over acting against the Seebeck cooling. Therefore a point is reached where applying additional power acts against the required effect of cooling. In the heating mode these two effects act together against conduction and no ceiling is reached. In practice the heating power vs. input current is approximately linear. Tins is why the design criteria centers around meeting the cooling rate requirements; the heating rate can always be achieved by the application of more power.

### Characterizing the Output of the TED's

The following equation describes the total heat flow from the cold side of a thermal electric cooler.

$$0 = 1/2^* \, R(t_{avg})^*I^2 + t_c \, ^*S(t_{avg})^*I - (k(t_{avg})^*(t_c - t_h) + Q_c)$$

where

$t_c$ = cold side temperature of cooler
$t_h$ = hot side temperature of cooler
$t_{avg}$ = average of $t_c$ and $t_h$
$R(t)$ = electrical resistance of cooler as a function of temperature
$S(t)$ = Seebeck coefficient of the cooler as a function of temperature
$K(t)$ = Conductance of cooler as function of temperature
**I** = electrical current applied to cooler
$Q_c$ = total heat flow from the cold side of the cooler

Given a desired heat flow, $Q_c$, and the hot and cold side temperatures, $t_c$ and $t_h$, the equation is solved for **I**, the current required to produce $Q_c$. The solution of this equation is used for three purposes:

1) To achieve linear temperature transitions or ramps.

For linear temperature transitions, constant thermal power is required. To maintain constant thermal power when temperatures $t_c$ and $t_h$ are changing, it is necessary to solve for **I** in equation 1 periodically. The result is the current then applied to the coolers. To compensate for errors a proportional integral derivative (PID) control loop is applied where:

Error input to PID = Set point Rate - Actual Rate
and Output from the PID is interpreted as percent Q

2) To achieve a linear PID temperature set point control algorithm over the desired temperature range:

Input to the PID control is the error signal $t_c$ - Set point.
Output from the PID control is interpreted as a % of $Q_{max}$.

Equation 1 is used to determine the current value, **I**, which will result in the % of $Q_{max}$ output by the PID control, under the current temperature conditions.

3) To achieve non-linear temperature transitions or ramps where temperature transitions arc defined by the derivative of temperature with respect to time, **dT/dt**, as a function of block temperature.

This function is approximated by a table containing Block temperature T, dT/dt data points in 5 C increments for cooling and by a linear equation for heating. The small effect of sample mass on dT/dt profiles, although measurable, is ignored. Knowing the total thermal mass, $MC_p$ (joules/°K), involved during temperature transitions, the amount of thermal power, Q (joules/sec), required to achieve the desired rate profile, dT/dt (°K/sec), is given at any temperature by the following equation:

$$Q = MC_p \, * \, dT/dt$$

The solution to equation 1 is used to determine the current value, **I**, which will result in the desired **Q** under the current temperature conditions. This process is repeated periodically during temperature transitions.

**Controlling overshoot and undershoot**

There is a practical limit to the ramp rates and the resulting cycle times that can be achieved. The sample has a time constant with respect to the block temperature that is a function of the sample tube and tube geometry which, because the tube is an industry standard, cannot be reduced. This means that even if the sample tube wall temperature is changed as a step function e.g. by immersion in a water bath, the sample will have a finite ramp time as the sample temperature exponentially approaches the set point. This can be compensated for by dynamically causing the block to overshoot the programmed temperature in a controlled manner. This means that the block temperature is driven beyond the set point and back again as a means of minimizing the time taken for the sample to reach the set point. As the possible ramp-rates increase, the overshoot required to minimize the time for the sample to reach the set point gets larger and a practical limit is soon reached. This occurs because although the average sample temperature does not overshoot the set point, the boundary liquid layer in the tube does overshoot to some extent. When cooling to the priming temperature, too great an overshoot can result in non-specific priming. Therefore the best advantage is to be gained in a system which utilizes this maximum ramp rate combined with optimized overshoots that are symmetrical on both up and down ramps.

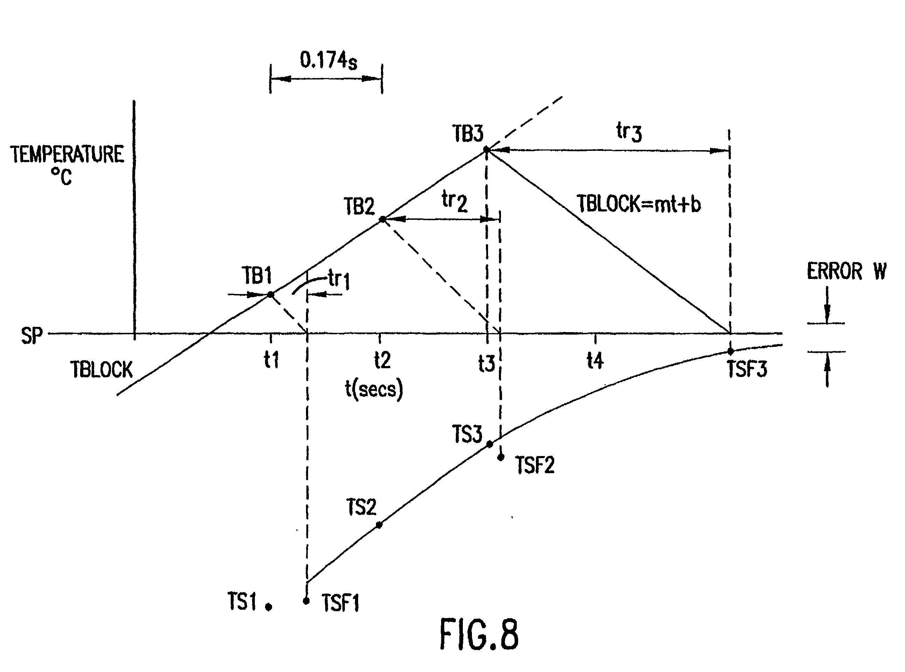

Figure 8 is a chart for predicting and compensating for temperature overshoots and undershoots. In order to drive the block temperature beyond the set point and back again in a controlled fashion the system first measures the block temperature, Tbn+1 and then solves the following equations:

$$Ts_{n+1} = Ts_n + (Tb_{n+1} - Ts_n)*0.174/RC$$

$$Tsf_n = (Tb_n - Ts_n - mRC)(1-e^{-tm/RC}) + mtr_n + Ts_n$$

where Tb is the measured block temperature, Ts is the calculated sample temperature, Tsf is the final calculated sample temperature if the block is ramped down at time $t_n$, R is the thermal resistance between the sample block and the sample, C is the thermal capacitance of the sample, m is the slope of a line defined by the points Tb and Tsf and tr is the time for the sample block to return to the set point if the system caused it to ramp toward the set point at the same rate it is was ramping away.

If the resulting $Tsf_n$ is within a particular error window around the set point then the system causes the sample block to ramp back to the set point at the same rate it was ramping away. If the resulting $Tsf_n$ is outside the particular error window then the system causes the sample block to continue to ramp away from the set point at the same rate. While ramping back toward the set point the same proportional integral derivative (PID) control loop described above is applied.

**Determining Sample Temperature**

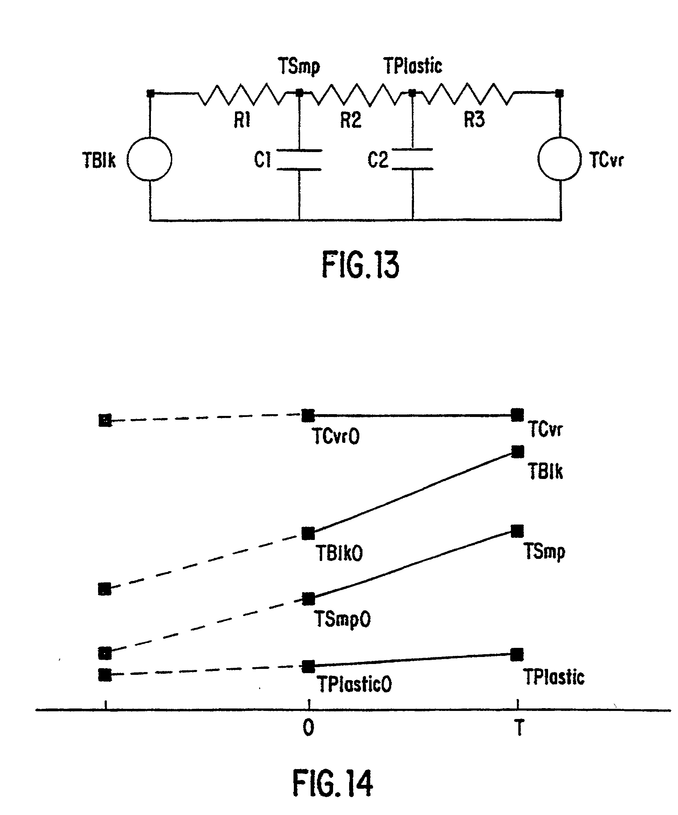

The temperature of a sample in a sample vial is determined by using the model illustrated in Figure 13 where:

TBlk is the measured baseplate temperature;
TSmp is the calculated sample temperature;
TPlastic is the calculated plastic temperature;
TCvr is the measured cover temperature;
R1 is the thermal resistance of the plastic vial between the block and sample mixture;
C1 is the thermal capacitance of the sample mixture;
R2 and R3 represent the thermal resistance of air in parallel with the plastic vial between the sample mixture and the cover; and
C2 is the thermal capacitance of the plastic vial between the sample mixture and the cover.

The model above is solved for TSmp(t) and TPlastic(t) given that: TBlk = mt + TBlk0, TCvr = K and initial conditions are non-zero. Taking initial conditions and the slope of TBlk to be the only variables, as illustrated in Figure 14, the equations are refactored giving equations for Tsmp and TPlastic.

Given the following relationships:

g1 = 1/R1;
g2 = 1/R2;
g3 = 1/R3;
a = (g1 + g2)/C1;
b = g2/C1;
f = g2/C2;
g=(g2+g3)/C2;

$$alpha = -(-g/2 -a/2 - (sqrt(g*g - 2*g*a + a*a +4*f*b))/2);$$

and

$$beta = -(-g/2 -a/2 + (sqrt(g*g - 2*g*a + a*a +4*f*b))/2),$$

the coefficients for the sample temperature equation become:

$$coef1 = (g3/C2)*(-b/(beta*(alpha-beta))*exp(-beta*T) + b/(alpha*beta) +$$

$$(b/(alpha*(alpha-beta)))*exp(-alpha*T))$$

$$coef2 = (b/(alpha-beta))*exp(-beta*T) - (b/(alpha-beta))*exp(-alpha*T)$$

$$coef3 = (g1/C1)*(g/(alpha*beta) + (-alpha+g)*exp(-alpha*T)/(alpha*(alpha-beta)) +$$

$$(beta-g)*exp(-beta*T)/(beta*(alpha-beta)))$$

$$coef4 = (g1/C1)*((g-beta)*exp(-beta*T)/(pow(beta,2)*(alpha-beta))-$$

$$g/(beta*pow(alpha,2)) + (1 + T*g)/(alpha*beta) + (-g+alpha)*exp(-$$

$$alpha*T)/(pow(alpha,2)*(alpha-beta))- g/(alpha*pow(beta,2)))$$

$$coef5 = (-g+alpha)*exp(-alpha*T)/(alpha-beta) + (g-beta)*exp(-beta*T)/(alpha-beta)$$

and the coefficients for the plastic vial temperature equation become:

$$coef6 = (g3/C2) * ((beta - a)*exp(-beta*T)/(beta* (alpha-beta)) + a/(alpha*beta) + (-$$

$$alpha+a)*exp(-alpha*T)/(alpha*(alpha-beta)))$$

$$coef7 = (-beta+a)*exp(-beta*T)/(alpha-beta) + (alpha-a)*exp(-alpha*T)/(alpha-beta)$$

$$coef8 = (g1/C1) * (f*exp(-beta*T)/(pow(beta,2)*(alpha-beta))- f/(beta*pow(alpha,2))-$$

$$f*exp(-alpha*T)/(pow(alpha,2)*(alpha-beta)) + T*f/(alpha*beta) - f/(alpha*pow(beta,2)))$$

$$coef9 = (g1/C1) * (-f*exp(-beta*T)/(beta*(alpha-beta)) + f/(alpha*beta) + f*exp(-$$

$$alpha*T)/(alpha*(alpha-beta)))$$

$$coef10 = f*exp(-beta*T)/(alpha-beta)- f*exp(-alpha*T)/(alpha-beta)$$

and

$$slope = (TBlk-TBlk0)/T \text{ where T is the sampling period (0.174sec)}$$

Utilizing the model in Figure 13 then,

$$TSmp = coef1*TCvr0 + coef2*TPlastic0 + coef3*TBlk0 + coef4*slope + coef5*TSmp0$$

$$TPlastic = coef6*TCvr0 + coef7*TPlastic0 + coef8*slope + coef9*TBlk0 + coef10*TSmp0$$

The coefficients are recalculated at the beginning of each PCR protocol to account for the currently selected sample volume. TSmp and TPlastic are recalculated for every iteration of the control task.
To determine the sample block set point, TBlkSP, during a constant temperature cycle, Tblk is determined using the equation for TSmp.

$$Tblk0 = (Tsmp - coef1*TCvr0 - coef2*TPlastic0 - coef4*slope - coef5*TSmp0)/coef3$$

When maintaining a constant temperature the slope = 0 and Tsmp = Tsmp0 = TSmpSP (sample temperature set point) and:

$$TBlkSP = (TSmpSP - coef1*TCvr - coef2*TPlastic - coef5*TSmpSP)/coef3$$

The equation for TBlkSP is solved on every pass of the control loop to update the sample block set point to account for changes in temperature of the plastic and cover.

**Calibration Diagnostics:**

The control software includes calibration diagnostics which permit variation in the performance of thermoelectric coolers from instrument to instrument to be compensated for so that all instruments perform identically. The sample block, thermal electric devices and heatsink are assembled together and clamped using the clamping mechanism described above. The assembly is then ramped through a series of known temperature profiles during which its actual performance is compared to the specified performance. Adjustments are made to the power supplied to the thermal electric devices and the process is repeated until actual performance matches the specification. The thermal characteristics obtained during this characterization process are then stored in a memory device residing on the assembly. This allows the block assembly to be moved from instrument to instrument and still perform within specifications.

**AC Resistance Measurement:**

The typical failure mode for the thermal electric devices is an increase in resistance caused by a fatigue failure in a solder joint. This results in an increase in the temperature of that joint which stresses the joint further, rapidly leading to catastrophic failure. It has been determined empirically that devices that exhibit an increase in AC resistance of approximately 5% after about 20,000 to 50,000 temperature cycles will shortly fail. The AC resistance of the thermal electric devices are monitored by the instrument to detect imminent failures before the device in question causes a thermal uniformity problem.
This embodiment automates the actual measurement using a feedback control system and eliminates the need to remove the thermal electric device from the unit. The control system compensates for the temperature difference between the two surfaces of the thermal electric device caused by the heat sink attached to one side and the sample block attached to the other. The control system causes the thermal electric device to equalize its two surface temperatures and then the AC resistance measurement is made. The micro-controller performs a polynomial calculation at the referenced time of the AC measurement to compensate for ambient temperature error.
Figure 9 shows the sample block **36**, a layer of thermal electric device **60** and heatsink **34** interfaced with the system microcontroller **62** and bipolar power amplifier **64**. The temperature sensor already present in the heatsink **38** and an additional temperature sensor attached to the sample block **36** with a clip (not shown) formed of music wire are utilized to determine the temperature differential of the surfaces of the thermal electric device.
The bipolar power amplifier supplies current in two directions to the device. Current in one direction heats the sample block and current in the other direction cools the sample block. The bipolar power amplifier also has signal conditioning capability to measure the AC voltage and AC current supplied to the thermal electric device. A band pass filter **68** is incorporated into the signal conditioning to separate an AC measurement signal from the steady state signal that produces a null condition for the temperature difference across the thermal electric device.
The micro-controller incorporates the necessary capability to process the measurement information and perform the feedback in real time. It also stores the time history of the AC resistance and the number of temperature cycles of the thermal electric device and displays the information to the operator on the display **70**. The AC measurement is normally done during initial turn on. However, it can be activated when self diagnostics are invoked by the operator using the keypad **72**. An analog to digital and digital to analog converter along with signal conditioning for the temperature sensors and AC resistance measurement is also integrated into the micro-controller in order for it to perform its digital signal processing.

**Sealing the Thermal Electric Device Area from the Environment.**

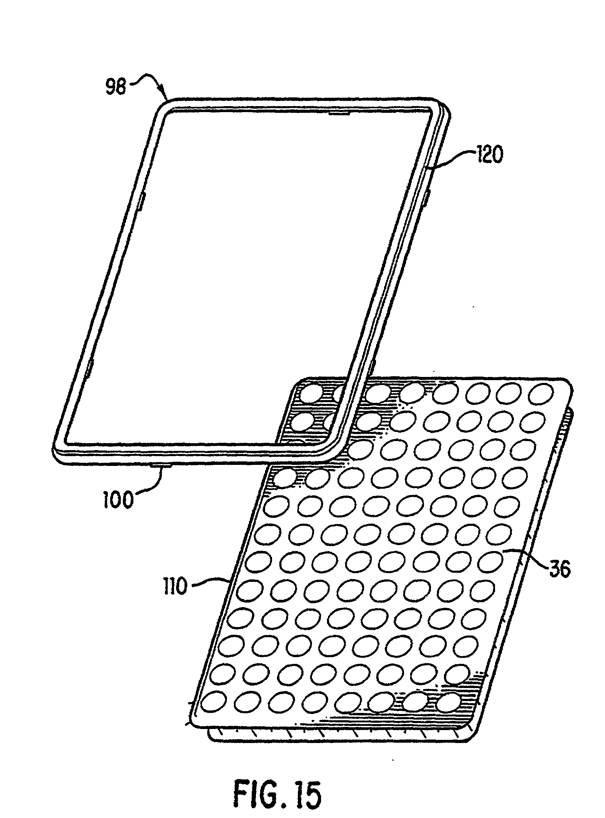

The thermal electric devices are protected from moisture in the environment by seals and the chamber is kept dry with the use of a drying agent such as silica gel. The seal connects from the silver electroform to the surrounding support and as such adds to the edge losses from the block. These losses are minimized by the use of a low thermal conductivity pressure seal **98** and by the use of the perimeter heater described above. The seal **98** has a cross-section generally in the shape of a parallelogram with several tabs **100** spaced about the lower surface of seal **98** for holding seal **98** to the edge of the sample block as shown in Figure 15.

The seal **98** is installed by first applying RTV rubber (not shown) around the perimeter 110 of the upper portion of the sample block. The seal **98** is then placed on the RTV rubber. More RTV rubber is applied to the perimeter **120** of the seal and then a cover (not shown) is installed which contacts the RTV rubber - seal combination. The cover has a skirt which also contacts a gasket (not shown) on the printed circuit board to effect a more effective seal.

**Claims**

1. An apparatus for performing the polymerase chain reaction in a plurality of liquid reaction mixtures; said apparatus including a plurality of vials containing such liquid reaction mixtures, said vials having an upper portion and a lower portion; said apparatus comprising:

   an assembly for cycling said vials through a series of temperature excursions;
   a cover (57) applying a seating force to said vials and for applying a constant temperature to the upper portion of said vials; and
   a computing apparatus for controlling said temperature excursions of said assembly and said constant temperature of said cover (57);
   said assembly comprising:

   a sample block (36) for receiving said vials;
   a plurality of thermoelectric devices (60);
   a heat sink (34);
   a clamping mechanism positioned so as to clamp said thermoelectric devices (60) between said sample block (36) and said heatsink (34);
   a heater (74) positioned loosely around the perimeter of said sample block (36); and
   a pin (24) having a first end and a second end, said first end in close contact with said sample block (36) and said second end in close contact with said heatsink (34) so as to provide a thermal path between said sample block and said heatsink.

2. The apparatus of claim 1 wherein said cover (57) comprises a heated platen (54) which presses on the cap perimeter of said vials.

3. The apparatus of claim 1 wherein said sample block comprises:

   a plurality of sample wells (20), for receiving sample vials, each well having a top and bottom;
   an upper support plate (21) connecting the tops of said sample wells (20); and
   a bottom plate (22) connecting the bottom of said sample wells.

4. The apparatus of claim 3 wherein said upper support plate (21) and said sample wells (20) are electroformed as a single piece.

5. The apparatus of claim 3 wherein said sample block (36) is comprised of silver.

6. The apparatus of claim 3 wherein said sample wells (20) are arranged in an 8 x 12 array.

7. The apparatus of claim 3 wherein sample block (36) is rectangular.

8. The apparatus of claim 1 wherein said plurality of thermoelectric devices (60) are matched to provide a temperature within 0.2 C for a given input current

9. The apparatus of claim 1 wherein said thermoelectric device (60) are Peltier devices and comprise:

   a first ceramic layer (26) having bonded copper traces (29);
   a second ceramic layer (26) having bonded copper traces (29), said second ceramic layer comprising a plurality of ceramic elements (32); and
   a plurality of bismuth telluride pellets (30) positioned between said first ceramic layer (26) and said second ceramic layer (26) and soldered to said bonded copper traces (29) on said first and second ceramic layers.

10. The apparatus of claim 9 wherein the ceramic of said first and second layer (26) is alumina.

11. The apparatus of claim 9 wherein the ceramic layers (26) have a thickness of 0.508mm.

12. The apparatus of claim 9 wherein said bismuth telluride pellets (30) are soldered using high temperature solder.

13. The apparatus of claim 9 wherein the resistivity of the devices is determined from the equation:

$$R = nr(h/A)$$

   where R is the resistivity of the device, n is the number of pellets, r is the resistivity of the bismuth telluride being used, h is the height of the pellet and A is the cross sectional area of the bismuth telluride.

14. The apparatus of claim 1 wherein said heatsink (34) comprises:

   a plate having a top side and a bottom side;
   a plurality of fins (37) extending perpendicularly from said bottom side;
   a trench (44) extending around the perimeter of said top side to impede heat loss from said perimeter;
   a fan placed in close proximity to said fins to control air flow through said fins; and
   a recess (40) within said plate for receiving a temperature sensor (38).

15. The apparatus of claim 1 wherein said clamping mechanism comprises:

   a spine (49) and said spine having a plurality of openings (53) in said spine for receiving fasteners (52);
   a plurality of fingers (48) extending laterally from said spine (49).

16. The apparatus of claim 15 wherein said spine (49) is rectangular in shape.

17. The apparatus of claim 15 wherein said fingers (48) are rectangular in shape.

18. The apparatus of claim 15 wherein said fingers (48) have a top and a bottom and are tapered so as to have less width at said top than at said bottom.

19. The apparatus of claim 15 wherein said fingers have a first end protruding laterally from said spine (49) and a protrusion extending downward from said first end.

20. The apparatus of claim 15 wherein said fingers (48) have a beveled front edge.

21. The apparatus of claim 15 wherein each of said openings (53) are located in close proximity to a corresponding finger.

22. The apparatus of claim 1 wherein said heater (74) comprises an electically resistive path embedded in a frame shaped film carrier.

23. The apparatus of claim 22 wherein said electrically resistive path comprises a first set of sections located on opposite sides of said frame shaped carrier having a first power density (76) and a second set of sections located on opposite sides of said frame shaped having a second power density (78).

24. The apparatus of claim 1 further comprising an associated memory device (96) capable of storing data related to said assembly.

25. The apparatus of claim 1, wherein
said cover (57) comprises:
a platen (54), vertically and horizontally displaceable in relationship to said vials, said platen including:

an array of openings (56) corresponding to locations of said vials, said openings having a perimeter corresponding to a perimeter of said vials;
a skirt (58) extending downward around the perimeter of said platen (54), said skirt having dimensions corresponding to the perimeter of said sample block, said skirt constructed to engage said perimeter of said block during vertical displacement of said platen, causing said openings (56) in said platen to engage said perimeter of said vials, applying a seating force on said vials for maintaining a snug fit between walls of said sample vials and said block for receiving said sample vials;
means for forcibly lowering said platen to maintain said seating force; and
heating means positioned in close contact with said platen (54) to maintain said platen at a constant temperature.

26. The apparatus of claim 1,

said apparatus further comprising a system for measuring the AC resistance of said thermoelectric devices (60),
said devices having a first heating and cooling surface and a second heating and cooling surface, said system comprising:

a first temperature sensor positioned so as to be in thermal communication with said first heating and cooling surface;
a second temperature sensor positioned so as to be in thermal communication with said second heating and cooling surface;
a bi-polar amplifier circuit (64) for providing power to said thermoelectric devices (60);
a circuit for sensing AC voltage across said thermoelectric device (60) and producing a DC voltage representing said AC voltage;
a circuit for sensing AC current through said thermoelectric devices (60) and producing a DC voltage representing said AC current;
a microcontroller (62) programmed to receive said signals from said first and second temperature sensors;
said microcontroller (62) further programmed to cause said bi-polar amplifier (64) to provide power to said thermoelectric devices(60) so that said first and second temperature sensor signals indicate equal temperatures;
said microcontroller (62) further programmed to cause an AC voltage to be superimposed on said bi-polar amplifier power;
said microcontroller (62) further programmed to receive said voltages produced by said circuit for sensing AC voltage and from said circuit for sensing AC current;
said microcontroller further programmed to calculate the AC resistance of said thermoelectric devices (60) from said voltages;
said microcontroller (62) further programmed to compensate for ambient temperature error by performing a polynomial calculation; and
said microcontroller (62) further programmed to store said compensated AC resistance measurement.

27. The apparatus of any one of the preceding claims, wherein said thermoelectric devices (60) are Peltier thermoelectric devices.

28. The use of the apparatus according to any one of claims 1 to 27 for performing the polymerase chain reaction, said use including the calculation of the AC resistance of said thermoelectric devices having a first heating and cooling surface and a second heating and cooling surface, comprising:

measuring the temperature of said first heating and cooling surface;

measuring the temperature of said second heating and cooling surface;

applying power to said thermoelectric devices to cause said first heating and cooling surface and said second heating and cooling surface to attain the same temperature;

applying an AC voltage across said thermoelectric devices;

measuring said AC voltage across said thermoelectric devices;

measuring AC current through said thermoelectric devices;

calculating the AC resistance of said thermoelectric devices from said measured AC voltage and said measured AC current.

**29.** The use of claim 28, further comprising:

performing a calculation for compensating for ambient temperature error to calculate a compensation AC resistance measurement; and

storing said compensated AC resistance measurement.

**30.** The use of the apparatus according to any one of claims 1 to 27 for performing the polymerase chain reaction, said use including achieving linear temperature transitions utilizing said thermoelectric devices having a first heating and cooling surface and a second heating and cooling surface and being operated in a manner causing said first surface to be higher in temperature and said second surface to be lower in temperature relative to each other, comprising the following steps:

determining a desired heat flow from said lower temperature surface;

determining electrical resistance of said thermoelectric devices as a function of temperature;

determining the Seebeck coefficient of said thermoelectric devices as a function of temperature;

determining the conduction of said thermoelectric devices as a function of temperature;

measuring the temperature of said lower temperature surface;

measuring the temperature of said higher temperature surface;

calculating the average temperature of said lower temperature surface and said higher temperature surface; and

calculating the current required to achieve said desired heat flow as a function of said electrical resistance of said thermoelectric devices as a function of temperature, said Seebeck coefficient of said thermoelectric devices as a function of temperature, said conductance of said thermoelectric devices as a function of temperature, said temperature of said lower temperature surface, said temperature of said higher temperature surface, and said average of said lower temperature surface and said higher temperature surface.

**31.** The use of the apparatus according to any one of claims 1 to 27 for performing the polymerase chain reaction, said use including determining the temperature of a mixture in said sample vial, comprising: by:

measuring the temperature of said sample block;

measuring the temperature applied by said cover,

determining the thermal resistance of said vial between said sample block and said mixture;

determining the thermal resistance of air in parallel with said vial between said mixture and said cover,

determining the thermal capacitance of said mixture;

determining the thermal capacitance of said vial between said mixture and said cover; and

calculating the temperature of said mixture as a function of said temperature of said sample block, said temperature applied by said cover, said thermal resistance of said vial between said sample block and said mixture, said thermal resistance of air in parallel with said vial between said mixture and said cover, said thermal capacitance of said mixture and said thermal capacitance of said vial between said mixture and said cover.

**Patentansprüche**

**1.** Eine Vorrichtung zur Durchführung der Polymerase-Kettenreaktion in einer Vielzahl von Reaktionsgemischen, wobei die Vorrichtung eine Vielzahl von Gefäßen umfasst, die solche flüssigen Reaktionsgemische enthalten, wobei die Gefäße einen oberen Abschnitt und einen unteren Abschnitt aufweisen, wobei die Vorrichtung umfasst:

eine Anordnung zum Zyklisieren der Gefäße durch eine Reihe von Temperaturverläufen;

eine geheizte Abdeckung (57) zum Anwenden einer Auflagekraft auf die Gefäße und zum Anwenden einer konstanten Temperatur auf den oberen Abschnitt der Gefäße; und

eine Rechenvorrichtung zum Steuern der Temperaturverläufe der Anordnung und der konstanten Temperatur der Abdeckung (57);

wobei die Anordnung umfasst:

einen Probenblock (36) zur Aufnahme der Gefäße;
eine Vielzahl von thermoelektrischen Vorrichtungen (60);
einen Kühlkörper (34);
eine Klemmvorrichtung, die so angeordnet ist, dass sie die thermoelektrischen Vorrichtungen (60) zwischen dem Probenblock (36) und dem Kühlkörper (34) festklemmt;
eine Heizeinrichtung (74), die lose um den Umfang des Probenblocks (36) angeordnet ist; und
einen Stift (24) mit einem ersten Ende und einem zweiten Ende, wobei das erste Ende in engem Kontakt mit dem Probenblock (36) und das zweite Ende in losem Kontakt mit dem Kühlkörper (34) steht, um einen thermischen Pfad zwischen dem Probenblock und dem Kühlkörper bereitzustellen.

2. Vorrichtung nach Anspruch 1, wobei die Abdeckung (57) eine geheizte Platte (54) umfasst, die auf den Kappenumfang der Gefäße drückt.

3. Vorrichtung nach Anspruch 1, wobei der Probenblock umfasst:

eine Vielzahl von Probenvertiefungen (20) zur Aufnahme von Probengefäßen, wobei jede Vertiefung ein Oberteil und einen Boden aufweist;
eine obere Stützplatte (21), welche die Oberteile der Probenvertiefungen (20) verbindet; und
eine Bodenplatte (22), die den Boden der Probengefäße verbindet.

4. Vorrichtung nach Anspruch 3, wobei die obere Stützplatte (21) und die Probenvertiefungen (20) als einstückiges Teil elektrogeformt sind.

5. Vorrichtung nach Anspruch 3, wobei der Probenblock (36) aus Silber aufgebaut ist.

6. Vorrichtung nach Anspruch 3, wobei die Probenvertiefungen (20) in einer 8 x 12-Gruppierung angeordnet sind.

7. Vorrichtung nach Anspruch 3, wobei der Probenblock (36) rechteckig ist.

8. Vorrichtung nach Anspruch 1, wobei die Vielzahl von thermoelektrischen Vorrichtungen (60) angepasst ist, um eine Temperatur innerhalb von 0,2°C für einen gegebenen Eingabestrom bereitzustellen.

9. Vorrichtung nach Anspruch 1, wobei die thermoelektrischen Vorrichtungen (60) Peltier-Vorrichtungen sind und umfassen:

eine erste Keramikschicht (26) mit daran gebundenen Kupferleitbahnen (29);
eine zweite Keramikschicht (26) mit daran gebundenen Kupferleitbahnen (29), wobei die zweite Keramikschicht eine Vielzahl von Keramikelementen (32) umfasst; und
eine Vielzahl von Bismuthtellurid-Pellets (30), die zwischen der ersten Keramikschicht (26) und der zweiten Keramikschicht (26) angeordnet sind und an die gebundenen Kupferleitbahnen (29) der ersten und zweiten Keramikschicht gelötet sind.

10. Vorrichtung nach Anspruch 9, wobei die Keramik der ersten und der zweiten Schicht (26) Aluminiumoxid ist.

11. Vorrichtung nach Anspruch 9, wobei die Keramikschichten (26) eine Dicke von 0,508 mm aufweisen.

12. Vorrichtung nach Anspruch 9, wobei die Bismuthtellurid-Pellets (30) mit einem Hochtemperaturlot gelötet sind.

13. Vorrichtung nach Anspruch 9, wobei der spezifische Widerstand der Vorrichtungen aus der Gleichung

$$R = nr(h/A)$$

bestimmt wird, wobei R der spezifische Widerstand der Vorrichtung, n die Anzahl der Pellets, r der spezifische Widerstand des verwendeten Bismuthtellurids, h die Höhe des Pellets und A die Querschnittsfläche des Bismuthtellurids ist.

**14.** Vorrichtung nach Anspruch 1, wobei der Kühlkörper (34) umfasst:

eine Platte mit einer Oberseite und einer Unterseite;
eine Vielzahl von Rippen (37), die sich senkrecht von der Unterseite erstrecken;
einen Graben (44), der sich um den Umfang der Oberseite erstreckt, um einen Wärmeverlust von dem Umfang zu erschweren;
einen Ventilator, der sehr nahe an den Rippen angeordnet ist, um den Luftstrom durch die Rippen zu steuern; und
eine Ausnehmung (40) innerhalb der Platte zur Aufnahme eines Temperatursensors (38).

**15.** Vorrichtung nach Anspruch 1, wobei der Klemmmechanismus umfasst:

einen Träger (49), der eine Vielzahl von Öffnungen (53) aufweist, um Befestigungselemente (52) aufzunehmen;
eine Vielzahl von Zinken (48), die sich lateral von dem Träger (49) erstrecken.

**16.** Vorrichtung nach Anspruch 15, wobei der Träger (49) eine rechteckige Form aufweist.

**17.** Vorrichtung nach Anspruch 15, wobei die Zinken (48) eine rechteckige Form aufweisen.

**18.** Vorrichtung nach Anspruch 15, wobei die Zinken (48) ein Oberteil und ein Unterteil aufweisen und konisch verjüngt sind, so dass sie am Oberteil eine geringere Breite aufweisen als am Unterteil.

**19.** Vorrichtung nach Anspruch 15, wobei die Zinken ein erstes Ende, das lateral von dem Träger (49) vorsteht und einen Vorsprung aufweisen, der sich von dem ersten Ende nach unten erstreckt.

**20.** Vorrichtung nach Anspruch 15, wobei die Zinken (48) eine abgeschrägte Vorderkante aufweisen.

**21.** Vorrichtung nach Anspruch 15, wobei jede der Öffnungen (53) sehr nahe an einem entsprechenden Zinken angeordnet ist.

**22.** Vorrichtung nach Anspruch 1, wobei die Heizeinrichtung (74) einen Pfad mit elektrischem Widerstand aufweist, der in einem rahmenförmigen Filmträger eingebettet ist.

**23.** Vorrichtung nach Anspruch 22, wobei der Pfad mit elektrischem Widerstand einen ersten Satz von Abschnitten, die auf gegenüberliegenden Seiten des rahmenförmigen Trägers angeordnet sind und eine erste Leistungsdichte aufweisen (76) und einen zweiten Satz von Abschnitten umfasst, die auf gegenüberliegenden Seiten des rahmenförmigen Trägers angeordnet sind und eine zweite Leistungsdichte aufweisen (78).

**24.** Vorrichtung nach Anspruch 1, die ferner eine dazugehörige Speichervorrichtung (96) umfasst, die Daten, die zu dieser Anordnung gehören, speichern kann.

**25.** Vorrichtung nach Anspruch 1, wobei die Abdeckung (57) umfasst:

eine Platte (54), die vertikal und horizontal bezüglich der Gefäße verschiebbar ist, wobei die Platte umfasst:
eine Gruppierung von Öffnungen (56), die den Positionen der Gefäße entsprechen, wobei die Öffnungen einen Umfang aufweisen, der einem Umfang der Gefäße entspricht;
einen Rahmen (58), der sich nach unten um den Umfang der Platte (54) erstreckt, wobei der Rahmen Abmessungen aufweist, die dem Umfang des Probenblocks entsprechen, wobei der Rahmen so konstruiert ist, dass er den Umfang des Blocks während einer vertikalen Verschiebung der Platte in Eingriff nimmt, wodurch die Öffnungen (56) in der Platte die Umfänge der Gefäße in Eingriff nehmen und eine Auflagekraft auf die Gefäße zur Aufrechterhaltung eines satten Anliegens zwischen den Wänden der Probengefäße und dem Block zur Aufnahme der Probengefäße ausüben;
eine Einrichtung zum Absenken der Platte unter Einwirkung einer Kraft, um die Auflagekraft aufrechtzuerhalten; und

eine Heizeinrichtung, die in engem Kontakt mit der Platte (54) angeordnet ist, um die Platte bei einer konstanten Temperatur zu halten.

26. Vorrichtung nach Anspruch 1, wobei die Vorrichtung ferner ein System zur Messung des Wechselstromwiderstands der thermoelektrischen Vorrichtungen (60) umfasst, wobei die Vorrichtungen eine erste Kühl- und Heizoberfläche und eine zweite Kühl- und Heizoberfläche aufweisen, wobei das System umfasst:

einen ersten Temperatursensor, der so angeordnet ist, dass er in thermischer Verbindung mit der ersten Heiz- und Kühlfläche steht;

einen zweiten Temperatursensor, der so angeordnet ist, dass er in thermischer Verbindung mit der zweiten Heiz- und Kühlfläche steht;

eine Bipolar-Verstärkerschaltung (64) zum Liefern von Leistung an die thermoelektrischen Vorrichtungen (60);

eine Schaltung zum Abfühlen der Wechselspannung über die thermoelektrischen Vorrichtungen (60) und zur Erzeugung einer Gleichspannung, die der Wechselspannung entspricht;

eine Schaltung zum Abfühlen des Wechselstroms durch die thermoelektrischen Vorrichtungen (60) und zur Erzeugung einer Gleichspannung, die dem Wechselstrom entspricht;

einen Mikrokontroller (62), der programmiert ist, um Signale von dem ersten und zweiten Temperatursensor zu empfangen;

wobei der Mikrokontroller (62) ferner programmiert ist, um den Bipolar-Verstärker (64) dazu zu veranlassen, Leistung an die thermoelektrischen Vorrichtungen (60) zu liefern, so dass der erste und der zweite Temperatursensor gleiche Temperaturen anzeigen;

wobei der Mikrokontroller (62) ferner so programmiert ist, dass er eine Überlagerung einer Wechselspannung auf die Bipolar-Verstärkerleistung verursacht;

wobei der Mikrokontroller (62) ferner so programmiert ist, dass er die durch die Schaltung zum Abfühlen der Wechselspannung und von der Schaltung zum Abfühlen des Wechselstroms erzeugten Spannungen empfängt;

wobei der Mikrokontroller ferner programmiert ist, um den Wechselstromwiderstand der thermoelektrischen Vorrichtungen (60) aus den Spannungen zu berechnen;

wobei der Mikrokontroller (62) ferner programmiert ist, um den Umgebungstemperatur-Fehler durch Ausführen einer Polynomberechnung zu kompensieren; und

wobei der Mikrokontroller (62) ferner programmiert ist, um die kompensierte Wechselstromwiderstandsmessung zu speichern.

27. Vorrichtung nach einem der vorstehenden Ansprüche, wobei die thermoelektrischen Vorrichtungen (60) thermoelektrische Peltiervorrichtungen sind.

28. Verwendung der Vorrichtung nach einem der Ansprüche 1 bis 27 zur Durchführung der Polymerase-Kettenreaktion, wobei die Verwendung die Berechnung des Wechselstromwiderstands der thermoelektrischen Vorrichtungen mit einer ersten Heiz- und Kühlfläche und einer zweiten Heiz- und Kühlfläche umfasst, umfassend:

Messen der Temperatur der ersten Heiz- und Kühlfläche;

Messen der Temperatur der zweiten Heiz- und Kühlfläche;

Anlegen einer Leistung an die thermoelektrischen Vorrichtungen, so dass die erste Heiz- und Kühlfläche und die zweite Heiz- und Kühlfläche die gleiche Temperatur erreichen;

Anlegen einer Wechselspannung über die thermoelektrischen Vorrichtungen;

Messen der Wechselspannung über die thermoelektrischen Vorrichtungen;

Messen des Wechselstroms durch die thermoelektrischen Vorrichtungen;

Berechnen des Wechselstromwiderstands der thermoelektrischen Vorrichtungen aus der gemessenen Wechselspannung und dem gemessenen Wechselstrom.

29. Verwendung nach Anspruch 28, ferner umfassend:

Durchführen einer Berechnung zur Kompensation des Umgebungstemperaturfehlers zur Berechnung einer Kompensations-Wechselstromwiderstandsmessung; und

Speichern der kompensierten Wechselstromwiderstandsmessung.

30. Verwendung der Vorrichtung nach einem der Ansprüche 1 bis 27 zur Durchführung der Polymerase-Kettenreaktion, wobei die Verwendung das Erreichen linearer Temperaturübergänge unter Verwendung der thermoelektrischen Vorrichtungen mit einer ersten Heiz- und Kühlfläche und einer zweiten Heiz- und Kühlfläche umfasst, die in einer Weise betrieben werden, dass die erste Fläche eine höhere Temperatur und die zweite Fläche eine niedrigere Temperatur relativ zueinander aufweisen, umfassend die folgenden Schritte:

Bestimmen eines gewünschten Wärmestroms von der Fläche mit der niedrigeren Temperatur;

Bestimmen des elektrischen Widerstands der thermoelektrischen Vorrichtungen als Funktion der Temperatur;

Bestimmen des Seebeck-Koeffizienten der thermoelektrischen Vorrichtungen als Funktion der Temperatur;

Bestimmen des Leitwerts der thermoelektrischen Vorrichtungen als Funktion der Temperatur;

Messen der Temperatur der Fläche mit der niedrigeren Temperatur;

Messen der Temperatur der Fläche mit der höheren Temperatur;

Berechnen der Durchschnittstemperatur der Fläche mit der niedrigeren Temperatur und der Fläche mit der höheren Temperatur; und

Berechnen des Stroms, der erforderlich ist, um den gewünschten Wärmestrom als Funktion des elektrischen Widerstands der thermoelektrischen Vorrichtungen als Funktion der Temperatur; des Seebeck-Koeffizienten der thermoelektrischen Vorrichtungen als Funktion der Temperatur; des Leitwerts der thermoelektrischen Vorrichtungen als Funktion der Temperatur; der Temperatur der Fläche mit der niedrigeren Temperatur; der Temperatur der Fläche mit der höheren Temperatur; und den Durchschnitt der Fläche mit der niedrigeren Temperatur und der Fläche mit der höheren Temperatur zu erreichen.

31. Verwendung der Vorrichtung nach einem der Ansprüche 1 bis 27 zur Durchführung der Polymerase-Kettenreaktion, wobei die Verwendung die Bestimmung der Temperatur eines Gemisches in dem Probengefäß umfasst, und zwar durch:

Messen der Temperatur des Probenblocks;

Messen der durch die Abdeckung angewandten Temperatur;

Bestimmen des Wärmewiderstands des Gefäßes zwischen dem Probenblock und dem Gemisch;

Bestimmen des Wärmewiderstands der Luft parallel zu dem Gefäß zwischen dem Gemisch und der Abdeckung;

Bestimmen des Entropie-Temperatur-Verhältnisses des Gemisches;

Bestimmen des Entropie-Temperatur-Verhältnisses des Gefäßes zwischen dem Gemisch und der Abdeckung;

Berechnen der Temperatur des Gemisches als Funktion der Temperatur des Probenblocks; der durch die Abdeckung angewandten Temperatur; des Wärmewiderstands des Gefäßes zwischen dem Probenblock und dem Gemisch; des Wärmewiderstands der Luft parallel zu dem Gefäß zwischen dem Gemisch und der Abdeckung; des Entropie-Temperatur-Verhältnisses des Gemisches und des Entrople-Temperatur-Verhältnisses des Gefäßes zwischen dem Gemisch und der Abdeckung.

## Revendications

1. Appareil pour la réalisation de la réaction d'amplification en chaîne par polymérase dans une pluralité de mélanges de réaction liquides, ledit appareil comprenant une pluralité de flacons contenant de tels mélanges de réaction liquides, lesdits flacons ayant une partie supérieure et une partie inférieure; ledit appareil comprenant:

un assemblage pour le cyclage des dits flacons à travers une série d'excursions de température;

un couvercle (57) pour l'application d'une force d'appui aux dits flacons et pour l'application d'une température constante à la partie supérieure des dits flacons; et

un appareil de calcul pour le suivi des dites excursions de température du dit assemblage et de ladite température constante du dit couvercle (57); ledit assemblage comprenant:

un bloc d'échantillon (36) pour la réception des dits flacons;

une pluralité de dispositifs thermoélectriques (60);

un dissipateur de chaleur (34);

un mécanisme de fixation positionné de façon à permettre de fixer lesdits dispositifs thermoélectriques (60) entre ledit bloc d'échantillon (36) et ledit dissipateur de chaleur (34);

un dispositif de chauffage (74) positionné de façon lâche autour du périmètre du dit bloc d'échantillon (36); et

une pointe (24) ayant une première extrémité et une seconde extrémité, ladite première extrémité en contact étroit avec ledit bloc d'échantillon (36) et ladite seconde extrémité en contact étroit avec ledit dissipateur de chaleur (34) de manière à procurer un trajet thermique entre ledit bloc d'échantillon et ledit dissipateur de chaleur.

**2.** Appareil selon la revendication 1, dans lequel ledit couvercle (57) comprend une platine chauffée (54) qui presse sur la périmètre des capsules de bouchage des dits flacons.

**3.** Appareil selon la revendication 1, dans lequel ledit bloc d'échantillon comprend:

une pluralité de puits (20), pour la réception de flacons d'échantillon, chaque puits ayant un sommet et un fond;
une plaque support supérieure (21) reliant les sommets des dits puits d'échantillon (20); et
une plaque de fond (22) reliant le fond des dits puits d'échantillon.

**4.** Appareil selon la revendication 3, dans lequel ladite plaque support supérieure (21) et lesdits puits d'échantillon (20) sont électroformés en une pièce unique.

**5.** Appareil selon la revendication 3, dans lequel ledit bloc d'échantillon (36) est composé d'argent.

**6.** Appareil selon la revendication 3, dans lequel lesdits puits d'échantillon (20) sont disposés selon une répartition de 8 x 12.

**7.** Appareil selon la revendication 3, dans lequel le bloc d'échantillon (36) est rectangulaire.

**8.** Appareil selon la revendication 1, dans lequel ladite pluralité de dispositifs thermoélectriques (60) ajustés pour fournir une température à 0,2°C près pour un courant d'entrée donné.

**9.** Appareil selon la revendication 1, dans lequel lesdits dispositifs thermoélectriques (60) sont des dispositifs Peltier et comprennent:

une première couche de céramique (26) ayant des traces de cuivre fixées (29);
une seconde couche de céramique (26) ayant des traces de cuivre fixées (29), ladite seconde couche de céramique comprenant une pluralité d'éléments de céramique (32); et.
une pluralité de pellets de tellurure de bismuth (30) positionnés entre ladite première couche de céramique (26) et ladite seconde couche de céramique (26) et soudées aux dites traces de cuivre fixées (29) sur lesdites première et seconde couches de céramique.

**10.** Appareil selon la revendication 9, dans lequel la céramique de ladite première et seconde couche de céramique (26) est en alumine.

**11.** Appareil selon la revendication 9, dans lequel les couches de céramique (26) ont une épaisseur de 0,508 mm.

**12.** Appareil selon la revendication 9, dans lequel lesdits pellets de tellurure de bismuth (30) sont soudés au moyen de soudure à haute température.

**13.** Appareil selon la revendication 9, dans lequel la résistivité des dispositifs est déterminée à partir de l'équation:

$$R = nr(h/A)$$

où R est la résistivité du dispositif, n est le nombre de pellets, r est la résistivité du tellurure de bismuth utilisé, h est la hauteur du pellet et A est l'aire de section transversale du tellurure de bismuth.

**14.** Appareil selon la revendication 1, dans lequel ledit dissipateur de chaleur (34) comprend:

une plaque ayant une face supérieure et une face inférieure;
une pluralité d'ailettes (37) s'étendant perpendiculairement à ladite face inférieure;
une rigole (44) s'étendant autour du périmètre de ladite face supérieure pour empêcher une perte de chaleur à partir du dit périmètre;

un ventilateur placé tout près des dites ailettes pour le réglage de l'écoulement d'air à travers lesdites ailettes; et une niche (40) dans ladite plaque pour recevoir un capteur de température (38).

**15.** Appareil selon la revendication 1, dans lequel ledit mécanisme de fixation comprend:

une pointe (49) et ladite pointe ayant une pluralité d'ouvertures (53) dans ladite pointe pour la réception d'éléments de fixation (52);
une pluralité de doigts (48) s'étendant latéralement à partir de ladite pointe (49).

**16.** Appareil selon la revendication 15, dans lequel ladite pointe (49) est de forme rectangulaire.

**17.** Appareil selon la revendication 15, dans lequel lesdits doigts (48) sont de forme rectangulaire.

**18.** Appareil selon la revendication 15, dans lequel lesdits doigts (48) ont un point haut et un point bas et sont effilés de manière à avoir une moindre largeur au dit point haut qu'au dit point bas.

**19.** Appareil selon la revendication 15, dans lequel lesdits doigts ont une première extrémité dépassant latéralement de ladite pointe (49) et une saillie s'étendant vers le bas à partir de ladite première extrémité.

**20.** Appareil selon la revendication 15, dans lequel lesdits doigts (48) ont une arête avant biseautée.

**21.** Appareil selon la revendication 15, dans lequel chacune des dites ouvertures (53) est très proche d'un doigt correspondant.

**22.** Appareil selon la revendication 1, dans lequel ledit dispositif de chauffage (74) comprend une ligne de résistances électriques noyée dans un support pelliculaire en forme de cadre.

**23.** Appareil selon la revendication 22, dans lequel ladite ligne de résistances électriques comprend une première série de sections situées sur des côtés opposés du dit support en forme de cadre ayant une première densité de courant (76) et une seconde série de sections situées sur des faces opposées du dit support en forme de cadre ayant une seconde densité de courant (78).

**24.** Appareil selon la revendication 1, comprenant en outre un dispositif mémoire associé (96) capable de stocker des données relatives au dit assemblage.

**25.** Appareil selon la revendication 1, dans lequel ledit couvercle (57) comprend:
une platine (54), déplaçable verticalement et horizontalement en relation avec lesdits flacons, ladite platine comprenant:

un agencement d'ouvertures (56) correspondant à des emplacements des dits flacons, lesdites ouvertures ayant un périmètre correspondant à un périmètre des dits flacons;
une lisière (58) s'étendant vers le bas autour du périmètre de ladite platine (54), ladite lisière ayant des dimensions correspondant au périmètre du dit bloc d'échantillons, ladite lisière étant conçue pour s'enclencher sur ledit périmètre du dit bloc pendant le déplacement vertical de ladite platine, pour provoquer l'engagement des dites ouvertures (56) de ladite platine dans ledit périmètre des dits flacons, l'application d'une force d'appui sur lesdits flacons pour maintenir un ajustage à frottement doux entre les parois des dits flacons d'échantillon et ledit bloc pour la réception des dits flacons d'échantillon;
des moyens pour un abaissement forcé de ladite platine pour maintenir ladite force d'appui; et
des moyens de chauffage positionnés en contact étroit avec ladite platine (54) pour maintenir ladite platine à une température constante.

**26.** Appareil selon la revendication 1, ledit appareil comprenant en outre un système pour la mesure de la résistance en courant alternatif des dits dispositifs thermoélectriques (60),
lesdits dispositifs ayant une première surface de chauffage et de refroidissement et une seconde surface de chauffage et de refroidissement, ledit système comprenant:

un premier capteur de température positionné de manière à être en communication thermique avec ladite première surface de chauffage et de refroidissement;

un second capteur de température positionné de manière à être en communication thermique avec ladite seconde surface de chauffage et de refroidissement;

un circuit amplificateur bipolaire (64) pour procurer de l'énergie aux dits dispositifs thermoélectriques (60);

un circuit pour sonder la tension du courant alternatif sur ledit dispositif thermoélectrique (60) et produire une tension de courant continu représentant ladite tension du courant alternatif;

un circuit pour sonder le courant alternatif à travers lesdits dispositifs thermoélectriques (60) et produire une tension de courant continu représentant ledit courant alternatif;

un microrégulateur (62) programmé pour recevoir lesdits signaux des dits premier et second capteurs de température;

ledit microrégulateur (62) programmé en outre pour faire que ledit amplificateur bipolaire (64) fournisse de l'énergie aux dits dispositifs thermoélectriques (60) de manière que lesdits premier et second signaux de capteur de température indiquent des températures égales;

ledit microrégulateur (62) programmé en outre pour faire qu'une tension du courant alternatif soit superposée sur ladite énergie de l'amplificateur bipolaire;

ledit microrégulateur (62) programmé en outre pour recevoir lesdites tensions produites par ledit circuit pour sonder la tension du courant alternatif et du dit circuit pour sonder le courant alternatif;

ledit microrégulateur programmé en outre pour calculer la résistance en courant alternatif des dits dispositifs thermoélectriques (60) provenant des dites tensions;

ledit microrégulateur (62) programmé en outre pour compenser l'erreur relative à la température ambiante en effectuant un calcul polynomial; et

ledit microrégulateur (62) programmé en outre pour stocker ladite mesure de résistance en courant alternatif compensée.

27. Appareil selon l'une quelconque des revendications précédentes, dans lequel lesdits dispositifs thermoélectriques (60) sont des dispositifs thermoélectriques de Peltier.

28. Utilisation d'un appareil selon l'une quelconque des revendications 1 à 27 pour la réalisation de la réaction d'amplification en chaîne par polymérase, ladite utilisation comprenant le calcul de la résistance en courant alternatif des dits dispositifs thermoélectriques ayant une première surface de chauffage et de refroidissement et une seconde surface de chauffage et de refroidissement, comprenant:

la mesure de la température de ladite première surface de chauffage et de refroidissement;

la mesure de la température de ladite seconde surface de chauffage et de refroidissement;

l'application d'énergie aux dits dispositifs thermoélectriques pour faire que ladite première surface de chauffage et de refroidissement et ladite seconde surface de chauffage et de refroidissement atteignent la même température;

l'application d'une tension de courant alternatif à travers lesdits dispositifs thermoélectriques;

la mesure de ladite tension de courant alternatif à travers lesdits dispositifs thermoélectriques;

la mesure du courant alternatif à travers lesdits dispositifs thermoélectriques;

le calcul de la résistance en courant alternatif des dits dispositifs thermoélectriques provenant de ladite tension de courant alternatif mesurée et du dit courant alternatif mesuré.

29. Utilisation selon la revendication 28, comprenant en outre:

la réalisation d'un calcul pour compenser l'erreur relative à la température ambiante pour calculer une mesure de résistance en courant alternatif de compensation; et

le stockage de ladite mesure de résistance en courant alternatif compensée.

30. Utilisation de l'appareil selon l'une quelconque des revendications 1 à 27 pour la réalisation de la réaction d'amplification en chaîne par polymérase, ladite utilisation comprenant l'accomplissement de transitions de température linéaires utilisant lesdits dispositifs thermoélectriques ayant une première surface de chauffage et de refroidissement et étant opérée d'une manière à amener ladite surface à être à une température supérieure et ladite seconde surface à être à une température inférieure l'une par rapport à l'autre, comprenant les étapes suivantes:

détermination d'un courant de chaleur souhaité à partir de ladite surface à température inférieure;

la détermination de la résistance électrique des dits dispositifs thermoélectriques en fonction de la température;

la détermination du coefficient de Seebeck des dits dispositifs thermoélectriques en fonction de la température;

la détermination de la conduction des dits dispositifs thermoélectriques en fonction de la température;

la mesure de la température de ladite surface à température inférieure;

la mesure de la température de ladite surface à température supérieure;

le calcul de la température moyenne de ladite surface à température inférieure et de ladite surface à température supérieure; et

le calcul du courant requis pour atteindre le flux de chaleur souhaité en fonction de ladite résistance électrique des dits dispositifs thermoélectriques en fonction de la température, du dit coefficient de Seebeck des dits dispositifs thermoélectriques en fonction de la température, de ladite conductance des dits dispositifs thermoélectriques en fonction de la température, de ladite température de ladite surface à température inférieure, de ladite température de ladite surface à température supérieure, et de ladite moyenne de ladite surface à température inférieure et de ladite surface à température supérieure.

31. Utilisation de l'appareil selon l'une quelconque des revendications 1 à 27 pour la réalisation d'amplification en chaîne par polymérase, ladite utilisation comprenant la détermination de la température d'un mélange dans ledit flacon d'échantillon, par:

mesure de la température du dit bloc d'échantillons;

mesure de la température appliquée par ledit couvercle;

détermination de la résistance thermique du dit flacon entre ledit bloc d'échantillons et ledit mélange;

détermination de la résistance thermique d'air en parallèle avec ledit flacon entre ledit mélange et ledit couvercle;

détermination de la capacitance thermique du dit mélange;

détermination de la capacitance thermique du dit flacon entre ledit mélange et ledit couvercle; et

calcul de la température du dit mélange en fonction de ladite température du dit bloc d'échantillons, de ladite température appliquée par ledit couvercle, de ladite résistance thermique du dit flacon entre ledit bloc d'échantillons et ledit mélange, de ladite résistance thermique d'air en parallèle avec ledit flacon entre ledit mélange et ledit couvercle, de ladite capacitance thermique du dit mélange et de ladite capacitance thermique du dit flacon entre ledit mélange et ledit couvercle.

FIG. 1

FIG. 10

FIG.2

FIG.2A

FIG.3

FIG.4

FIG. 5

UP RAMP POWER CURVES

FIG.6

DOWN RAMP POWER CURVES

FIG. 7

FIG.8

EP 0 963 250 B1

FIG. 9

EP 0 963 250 B1

FIG.11

FIG.12

FIG.13

FIG.14

FIG. 15